# EUROPEAN PATENT APPLICATION

(11) **EP 0 810 648 A2**
(43) Date of publication of application: **03.12.1997**
(21) Application number: 97303474.7
(22) Date of filing: 21.05.1997
(51) Int. Cl.: H01L 21/44, H01L 21/302

(54) **Improvements in or relating to semiconductor devices**

(30) Priority: 31.05.1996 US 18737 P
(71) Applicant: TEXAS INSTRUMENTS INCORPORATED, Dallas Texas 75265 (US)
(72) Inventor: Marsden, Mary H., Austing, TX 78759 (US); Atnip, Earl V., Plano, TX 75023 (US); Krocak, Pavel, Garland, TX 75043 (US)
(74) Representative: Nettleton, John Victor

(57) **Abstract**

A process is provided for implementing inter-metal dielectric ("ILD") planarization using hydrogen silsesquioxane ("HSQ") (66) spin-on glass ("SOG") and conformal plasma enhanced tetraethyloxysilane ("PETEOS") (68) for submicron gaps, such as vias (72) and interconnects (58,80), having sputtered metal interconnects. Via poisoning is prevented by using a furnace bake prior to metal deposition. The invention is particularly suitable for use in submicron CMOS and BiCMOS, processes, such as those related to the manufacture of digital signal processors, memory, logic circuits, application specific and other process that use a minimum of double-layer metallization.

## Description

### FIELD OF THE INVENTION

This invention relates to semiconductor devices, and more particularly to a process for forming a planar intermetal dielectric layer for submicron apertures.

### BACKGROUND OF THE INVENTION

As geometries in semiconductor circuits have shrunk to and below 0.5 microns, demands upon the inter-level dielectric (ILD) films for the interconnect patterns in the semiconductor circuits have become increasingly stringent. Future contemplated ILD films will be called upon to fill gaps with higher aspect ratios and provide lower dielectric constants than are required of the ILD films currently in use. Reduction of the dielectric constant for the film is desirable, as such a reduction results in a reduction in both inter-level and intra-level capacitance, both of which retard the operational speed of circuits processed with oxides presently used for electrical isolation. It is well known that this retarding effect becomes progressively more severe as the circuit complexity increases.

Moreover, as the circuitry of integrated circuit devices becomes more complex and more dense, the number of layers of metallurgy must also increase. With this increase in number of metallurgy layers, the surface planarity of each successive layer becomes more non-planar due to associated interlayer films following the contour of underlying metallurgy stripes and supporting layers. With each successive layer, there exists a greater number of metallurgy layers to contribute to the irregularity of the surface contour. As such, structures having two or more levels can develop severe non-planar topographies, and may face severe reliability problems as the result of poor metal step-coverage and poor microlithographic delineation processes.

Both inorganic and organic layers deposited by spin-on-glass ("SOG") techniques have been widely used for microminiaturized multilevel interconnection circuitry. The deposited dielectric layers have conventionally been subjected to an etch-back process which further smoothens the surface. However, this layer etch-back step adds an extra step in the process for each layer deposited which, in turn, results in added cost and the potential for reducing product yield. While inorganic SOG can be planarized by heating, thereby allowing for avoidance of the foregoing etch-back step, other process-oriented problems can arise which compromise the objective of ILD planarization. For example, when ILD layers are subjected to O₂ plasma incident to the removal of photoresist that is used incident to via formation, H₂O can be absorbed into the layer, which is deleterious to the associated metallurgy.

Moreover, when organic SOG is exposed while in vias, the SOG contains outgassed moisture or other substances that cause high resistances to be encountered in the vias when electrically conductive metals are sputtered into the vias. This problem is known as "via poisoning" and arises when methylsiloxane-based spun on glass is used for gap fill and planarization of integrated circuits with multiple levels of metal interconnect. The quality of chemical vapor deposited (CVD) tungsten in vias which have such organic SOG exposed in the via sidewalls is severely compromised, often resulting in incompletely filled vias, vias with high resistance and metal growth (hillocks) from the tops of vias that cause short circuits with other metal lines. It is believed that the organic portion of the organic SOG reacts in some adverse way with the tungsten source materials. A discussion of further difficulties encountered with the deposition of insulating semiconductor interlayers can be found in specification and cited references of U.S. Patent No. 5,413,963 that issued on 9 May 1995.

One common solution to the problem of via poisoning is to perform a partial plasma etch-back of the SOG, leaving the SOG only between, or along, the sides of metal leads. This solution requires that semi-organic glass be deposited over the entire wafer with etch back in a plasma etcher. This procedure is very slow, very "dirty", leaving a multitude of particles on the wafer that can interfere with further wafer processing steps, and is not uniform. Other approaches use thinner coats of SOG, such as by moving the vias to locations where the SOG layer is thinner or in conjunction with careful cure, etch, via bake and metal deposition procedures, with varying degrees of success.

ILD structure decisions are commonly driven by defect levels, process complexity, electrical performance, and planarization capabilities. The foregoing categories are all areas in which flowable oxides have shown promise. The flowable nature of flowable oxide materials is attractive, for it can simplify ILD processing and is capable of providing exceptional gap fill and planarization performance. Superior planarization has been demonstrated for flowable oxide-based ILD processes integrated in 0.7 µm technology as compared to plasma enhanced tetraethyloxysilane ("PETEOS") oxide deposition and/or etch processes. However, the high wet etch rate of HSQ complicates via etching, and the desired "champagne glass" slope of via sidewalls cannot be formed solely from a wet etch process. Instead, other process steps are required, which contributes to the expense, complexity and time associated with device manufacture.

### SUMMARY OF THE INVENTION

A process is provided for implementing inter-metal dielectric ("ILD") planarization using hydrogen silsesquioxane ("HSQ") spin-on glass ("SOG") and conformal plasma enhanced tetraethyloxysilane ("PETEOS") for submicron gaps, such as vias and interconnects, having sputtered metal interconnects. The invention is particularly suitable for use in submicron CMOS and BiCMOS processes, such as those related to the manufacture of digital signal processors, memory devices, logic circuits, as well as application specific and other processes that use a minimum of double-layer metallization. The incidence of via poisoning that has previously been encountered in the creation of interlevel connections, such as vias and the like, has been reduced by modifying the post-interlevel connection or via-etch cleansing process to more completely remove complexes formed between water molecules, organic cleansing solvents, such as isopropyl alcohol, and HSQ residue in the interlevel connection channels.

### BRIEF DESCRIPTION OF THE DRAWINGS

The present invention will now be further described, by way of example, with reference to the accompanying drawings in which:-
FIGURES 1A to 1G depict a process flow for a prior art procedure for providing a planarized dielectric layer over an interconnect pattern for a DRAM;
FIGURES 2A to 2I depict a process flow for a prior art procedure for providing a planarized dielectric layer over an interconnect pattern for a logic circuit;
FIGURES 3A to 3N depict a tri-layer metal process flow in accordance with the present invention which can be used for both DRAM and logic circuit fabrication;
FIGURES 4A to 4C depict a bi-layer metal process flow in accordance with the present invention which can be used for both DRAM and logic circuit fabrication;
FIGURE 5 is a spectrograph of a poisoned via; and
FIGURE 6 is a chart comparing test site failures for wafer lots processed in a conventional manner as well as lots processed in accordance with the teachings of the present invention.

### DETAILED DESCRIPTION OF THE PREFERRED EMBODIMENTS

It is to be understood and appreciated that the process steps and structures described below do not form a complete process flow for the manufacture of integrated circuits. The present invention can be practiced in conjunction with integrated circuit fabrication techniques that are currently used in the art, and only so much of the commonly practiced process steps are included herein as are necessary to provide an understanding of the present invention. The drawing figures that are included with this specification and which represent cross-sections of portions of an integrated circuit during fabrication are not drawn to scale, but instead are drawn so as to illustrate the relevant features of the invention.

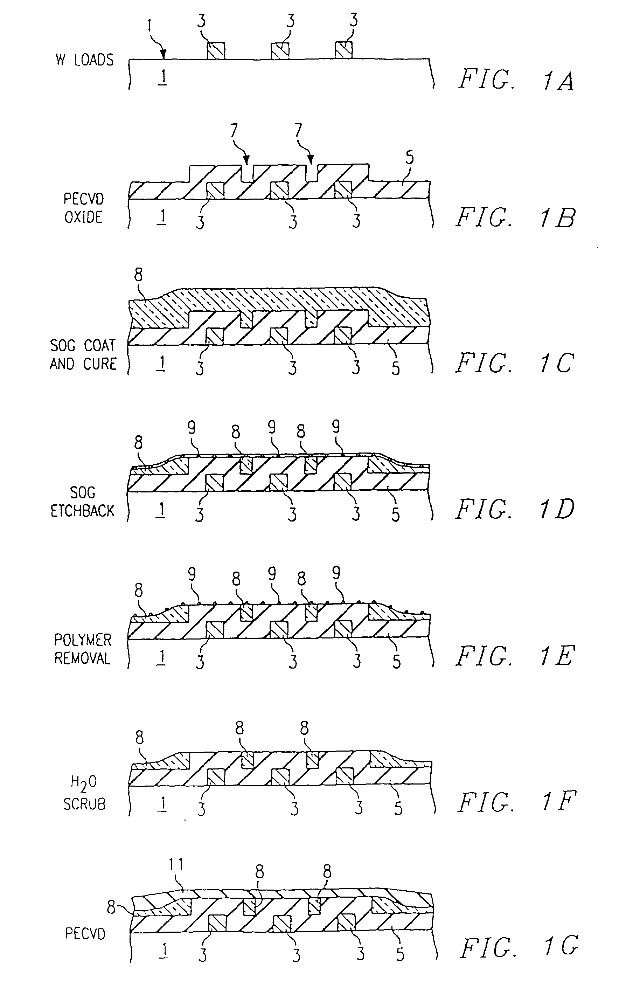

Referring first to FIGS. 1A to 1G, there is shown a process flow for a prior art procedure for providing a planarized dielectric layer over an interconnect pattern for an integrated circuit device such as a dynamic random access memory "DRAM" device. Initially, the interconnect pattern 3 is formed on a substrate 1 by deposition of the interconnect metal, such as tungsten, with subsequent patterning and etching as shown in FIG. 1A. A 7,000 Å layer of plasma TEOS oxide 5 is then deposited over the exposed surface, leaving indentations or valleys 7 in the region between portions of the interconnect pattern as shown in FIG. 1B. A 6,200 Å to 6,400 Å layer of organic SOG 8 is then deposited over the structure of FIG. 1B and cured as shown in FIG. 1C or etched back and then cured. The structure of FIG. 1C is then etched back if not previously etched back until the TEOS oxide 5 is exposed as shown in FIG. 1D and then any polymers 9 collected on the structure are removed by an oxygen plasma treatment as shown in FIG. 1E. Any remaining polymer and dirt is then removed from the surface with a water scrub as shown in FIG. 1F. The structure is then baked at a temperature of 410°C for about 2 1/2 minutes and a 5,000 Å layer of TEOS oxide 11 is then deposited over the surface as shown in FIG. 1G to provide the planarized surface.

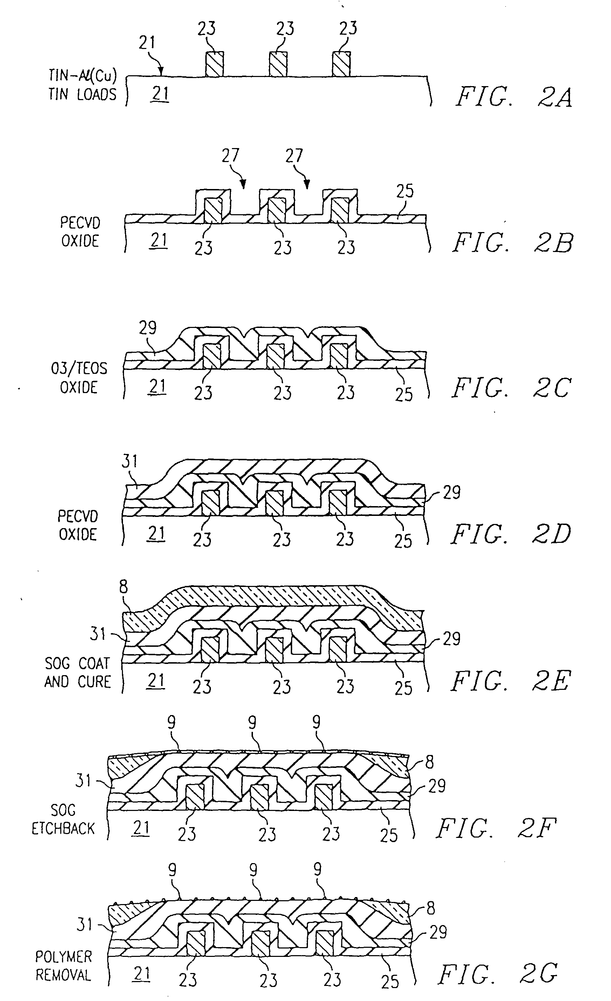

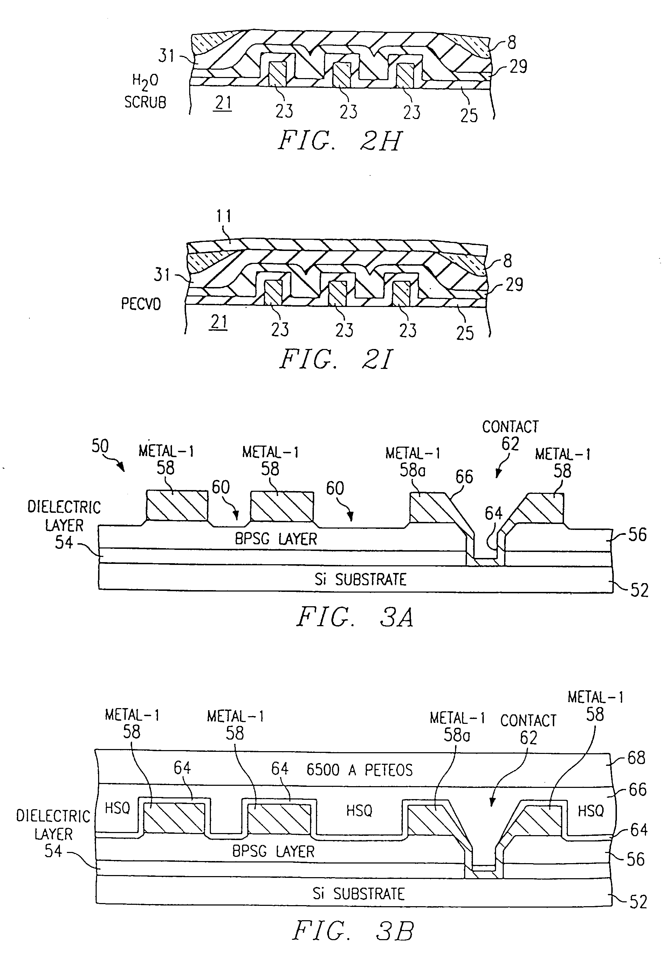

Referring now to FIGS. 2A to 2I, there is shown the process flow for a prior art procedure for providing a planarized dielectric layer over an interconnect pattern for a logic circuit. Initially, the interconnect pattern 23 is formed on a substrate 21 by deposition of the interconnect metal, such as aluminum, with subsequent patterning and etching as shown in FIG. 2A. Since aluminum can form hillocks which can cause short circuits with overlying interconnect layers, it is necessary to provide a thicker dielectric layer than is required in the DRAM embodiment.

Therefore, a 3,000 Å layer of plasma TEOS oxide 25 is deposited over the exposed surface, leaving indentations or valleys 27 in the region between portions of the interconnect pattern as shown in FIG. 2B. This is followed by a nitrogen plasma treatment which is then followed by a 3,000 Å layer of ozone TEOS oxide 29 as shown in FIG. 2C and then by a 4,000 Å layer of plasma TEOS oxide 31 as shown in FIG. 2D. The procedure is then the same as explained hereinabove for the DRAM with reference to FIGS. 1C to 1G, which correspond to FIGS. 2E to 2I, respectively.

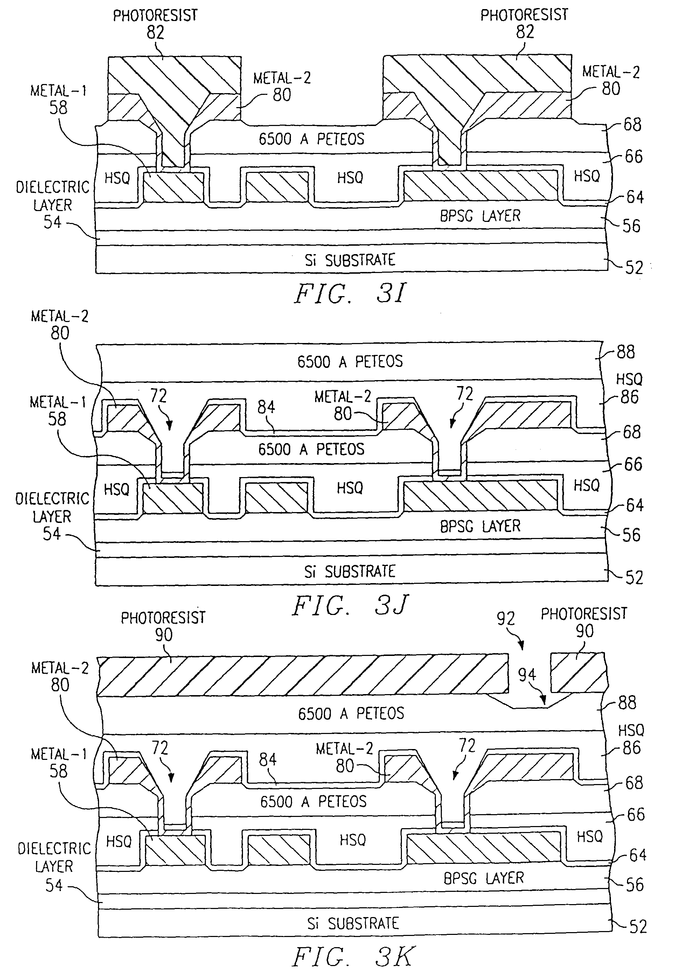

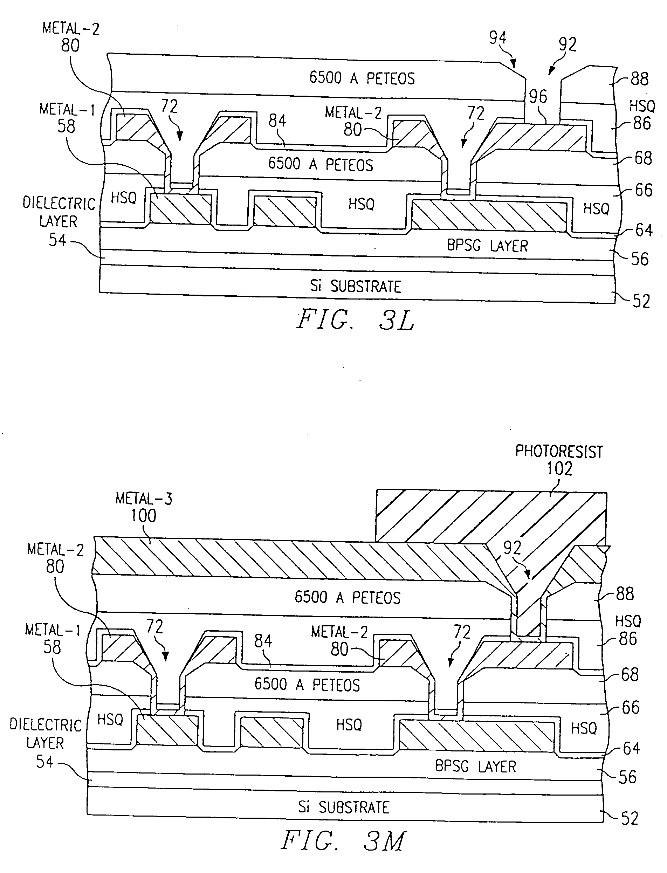

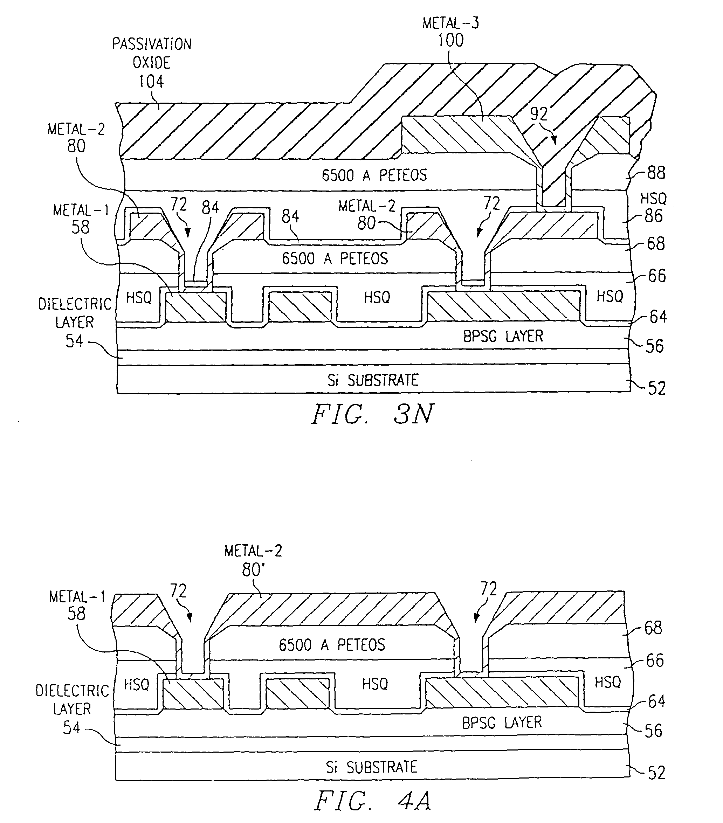

Details of the invention in connection with a triple layer metal process are illustrated in FIGS. 3A - 3N. With particular reference to FIG. 3A, there is illustrated a portion 50 of a semiconductor device under construction. At this stage of construction, the portion 50 is comprised of a Silicon substrate 52 that underlies a dielectric layer 54. The dielectric layer 52 can be comprised of a tri-level sandwich of an underlying ∼6,200 Å thermal oxide which underlies an ∼7,500 Å plasma enhanced tetraethyloxysilane ("PETEOS"). Sandwiched between the thermal oxide and the PETEOS is an ∼300 Å silane oxide layer provided to reduce implant channeling, thus rendering a total dielectric layer thickness of about 14,100 Å. A further dielectric layer, in the form of a Boro-Phospho-Silicate Glass ("BPSG") layer 56, is deposited and densified in a conventional manner, as by processing in a Watkins-Johnson reactor with N2. The composition of the BPSG can be as follows: Boron 2.4-3.2 wt.%; Phosphorus 5.9-6.25 wt.%; and balance Silicon, although other BPSG compositions are contemplated for use in the present invention. The HSQ layer 66 is applied to a thickness of about 5,700 Å, preferably while the silicon wafer is rotating at a speed of about 500 RPM. The layer 66 can be thinned-out by rotating at higher speeds, such as 2,500 RPM.

A metal stack 58, designated as "Metal-1", is deposited in situ over the BPSG layer. In a preferred aspect of the invention, the Metal-1 stack is comprised of a vertical array of three sputtered metals: an underlying 500 Å layer of Titanium that is deposited adjacent to the BPSG layer 56; an overlying 3,000 Å thick layer of Ti(10%)-W; and an uppermost ∼4,600 Å layer of Al-Si (1%) - Cu (0.5%). Thus, the total thickness of the Metal-1 stack is about 8,100 Å. Following stack deposition, it is patterned using conventional photolithographic techniques and etched. Etching removes about 2,000 Å of the BPSG layer 56 incident to a metal "over-etch", indicated by the recesses 60 in the drawing. The over-etch can create an effective metal stack height of in excess of ∼10,000 Å, which will be planarized with dielectrics in subsequent process steps, as will be described in detail below. A contact 62 extends through one of the metal stacks, designated 58a, and through the BPSG and dielectric layers 56 & 54, respectively. The inner surface 64 of the contact 62 is lined with metal from the tri-layer metal stack 58, as is shown in the drawing. The upper surfaces 66 of the contact are constructed along divergent planes to establish a desired "champagne glass" or "martini glass" contour which is preferred to facilitate contact filling in the manner set forth below. The contact 62 can be formed by any of a variety of suitable processes, including an initial wet etch, followed by dry etch which, in turn, is followed by a reduced-power soft etch.

As is depicted in FIG. 3B, a 1,000 Å layer of conformal plasma enhanced TEOS oxide 64 is deposited over the structure 50.

Thereafter, an approximately ∼5,700 Å layer 66 of hydrogen Silsesquioxane ("HSQ") is spun-on and baked. It is to be appreciated that reference to the HSQ thickness pertains to the thickness of the HSQ that is obtained when the material is spun-on a bare silicon wafer under standard processing conditions. It is to be appreciated that the thickness of the HSQ on a patterned wafer is a function of local wafer topography. For example, the thickness will be greater than the above-referenced 5,700 Å between closely-spaced metal lines, and will correspondingly thin-out in open areas. The overall effect is a high degree of topography smoothing and short range planarization, as very little HSQ remains over narrow, isolated leads, while the thickness over wide leads or closely spaced, narrow leads can be expected to be a considerable fraction of the above-referenced thickness.

The HSQ film 66 is cured in an atmospheric furnace at about 400°C with a nitrogen ambient. Following thermal processing, the wafer carrying the device 50 is inserted into an PETEOS CVD chamber (not shown) and, prior to deposition of subsequent layers, the wafer is baked at about ∼380°C at ∼ 8 Torr for about 60 seconds in a nitrogen ambient. Following nitrogen thermal processing, an ∼6,500 Å layer 68 of PETEOS is deposited. Deposition of PETEOS is advantageous, as it is conformal and can be deposited at a relatively low temperature (<400°C) so as to minimize granule formation in the associated metal stacks.

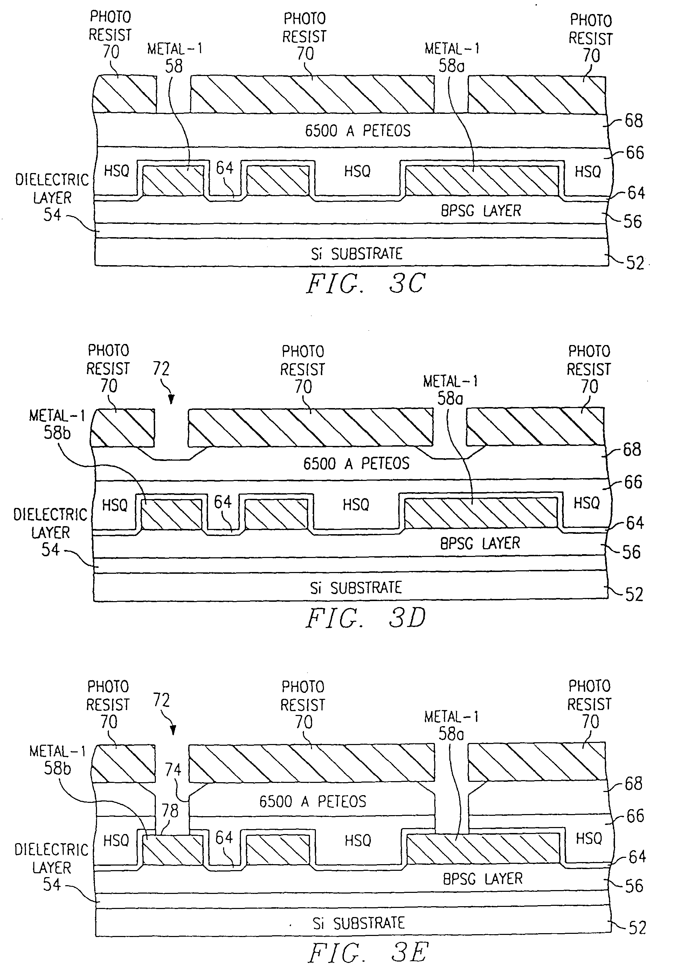

With reference to FIGS. 3C & 3D, the wafer 50 is patterned using conventional photolithography techniques to define the location of the vias and/or locations where metal-1 stack 58 will need to form an ohmic contact with a subsequently-applied metal-2 stack. This patterning is illustrated by shadow boxes 70 in FIG. 3C. The contact 62 appearing in FIGS. 3A & 3B has been omitted from FIG. 3C and subsequent drawings for the purpose of simplification and clarity.

Following photoresist patterning, the wafer 50 is baked to harden the photoresist. Thereafter, the photoresist 70 is etched in an aqueous buffered oxide etch solution comprising 6.5% HF and 35% NH₄F with Olin Hunt surfactant and COE with DHS. A result of this etching is an isotropic etch profile that removes approximately ∼3000-5000Å of the upper PETEOS layer 68. Processing conditions are controlled to ensure that etching does not eradicate all of the PETEOS layer 68 and invade the underlying HSQ layer 66, as the HSQ would be rapidly removed from the wafer in an HF solution. It is to be appreciated that etching through the PETEOS 68 and into the HSQ layer 66 would prevent adequate metal coverage of the via during subsequent metal sputtering. Etching of the PETEOS layer 68 in the foregoing manner results in the development of a well 72 that extends partially under the patterned photoresist 70.

Following formation of the well 72, the wafer 50 is then etched in a plasma reactor using CF₄/CHF₃ chemistry to remove the remaining oxide in the via 72. Plasma reactor etching results in the formation of a via having substantially straight sidewalls 74 and a desired "martini" or "champagne" glass configuration at the open end of the via. The openings of the bottom of the vias following the via etch are about 1.1µm. The foregoing plasma reactor etch also etches through approximately ∼0.85µm (8,500 Å) of dielectric layers (PETEOS 68 and HSQ 66) overlying the upper surface 78 of associated metal leads such as lead 58b in FIG. 3E. Via etching in the foregoing manner yields a via aspect ratio of about 0.77.

Following formation of the vias 72 in the manner described above, the photoresist 70 is removed in a conventional manner, such as solvent clean/rinse, plasma ash, solvent/clean rinse and plasma ash, to render a structure as shown in FIG. 3F that is substantially devoid of photoresist. The last ash step has been found to be particularly effective at removing any solvents that may have been absorbed by the HSQ in the via sidewalls. Each solvent step provides cleansing in an Ashland ACT-CMI DMAC clean, followed by an IPA rinse/vapor dry. Each ash is performed in a barrel asher in an oxygen plasma atmosphere.

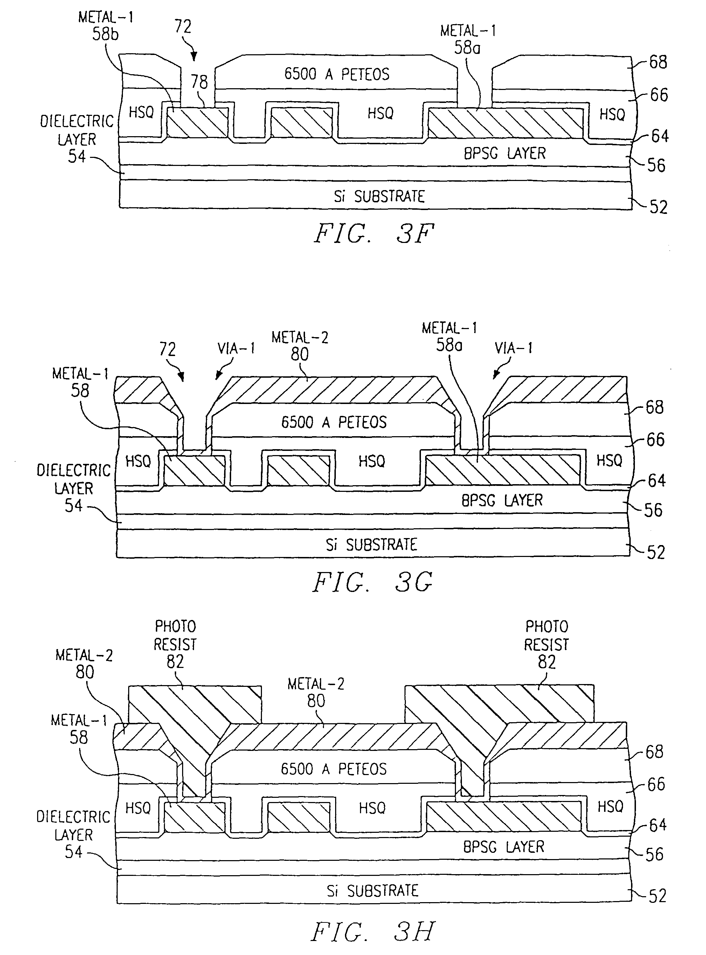

With reference to FIG. 3G, there is depicted application of a second metal stack 80, designated "Metal-2". Prior to application of metal-2 stack 80, the wafer receives an argon sputter etch to remove any residue and aluminum from the lower surface of the vias 72. The argon sputter etch is undertaken to remove ∼180 Å + 20 Å of silane (SiH₄) oxide. In addition, wafers are subjected to a low pressure bake. The Metal-2 layer 80 is comprised of combination of ∼2,000 Å Ti(10 wt.%)-W and ∼4,600 Å Al-Si(wt.%)-Cu(0.5 wt.%) that are sputtered onto the wafer. As is indicated in the drawing, the sputter process partially fills the vias 72 with metal to create a path for an electrical conduction between Metal-1 layer 58 and Metal-2 layer 80. However, voids or cavities remain in the vias 72 which will be filled with an oxide as will be described below. Overall metal stack height for Metal-2 layer 80 at its thickest point is approximately 6,600 Å.

Once the Metal-2 stack 80 has been applied, the wafers are processed through photolithography (FIG. 3H) to define a pattern for the Metal-2 stack 80. The patterning is illustrated by shadow boxes 82 in FIG. 3H. As is shown in FIG. 3I, the etching of the Metal-2 stack 80 can remove up to about 2,000 Å of PETEOS oxide while thereby rendering an effective step height of about 8,000 Å that will require planarization. The photoresist 82 is then removed in a conventional manner, and a 1,000 Å PETEOS layer 84 is applied over Metal-2 stack 80 and the exposed portion of PETEOS dielectric layer 68. HSQ layer 86 of approximately 5700 Å is applied over the 1,000 Å dielectric layer 84. In addition, a further PETEOS layer 88 of a approximately 6,500 Å is deposited over the HSQ layer 86 in the manner described above in connection with FIG. 3B. The 1,000 Å PETEOS layer 84 deposits into the via 72, with HSQ 86 filling the remainder of the void.

Following application of the dielectric layers 84-88, the circuit 50 is patterned with photoresist incident to formation of a second via layer, as will now be described. With reference to FIG. 3K, the patterned photoresist 90 is baked and then etched in the manner described previously in connection with FIG. 3D. Etching in this manner results in the formation of second via 92 having the desired "martini" or "champagne" glass open end, as indicated by reference character 94. The wafer is then etched in a plasma reactor to complete the via etch process (FIG. 3L), thereby fully developing the via 92 so as to extend completely through PETEOS layer 88, HSQ layer 86 and underlying PETEOS layer 84 to the upper surface 96 of Metal-2 stack 80.

With reference to FIG. 3M, there is illustrated construction for a Metal-3 stack 100. The Metal-3 stack 100 is deposited in an analogous manner as that described previously in connection with Metal-2 stack 80. The Metal-3 stack 100 is comprised of ∼2,000 Å Ti(10 wt.%)-W and ∼6,000 Å Al-Si (1 wt. %) - Cu (0.5 wt.%) and is patterned with photoresist, as indicated by phantom box 102. Following patterning and etching of Metal-3 stack 100, the photoresist 102 is removed, and a layer of passivation before is deposited, patterned and etched, thereby rendering the structure illustrated in FIG. 3N.

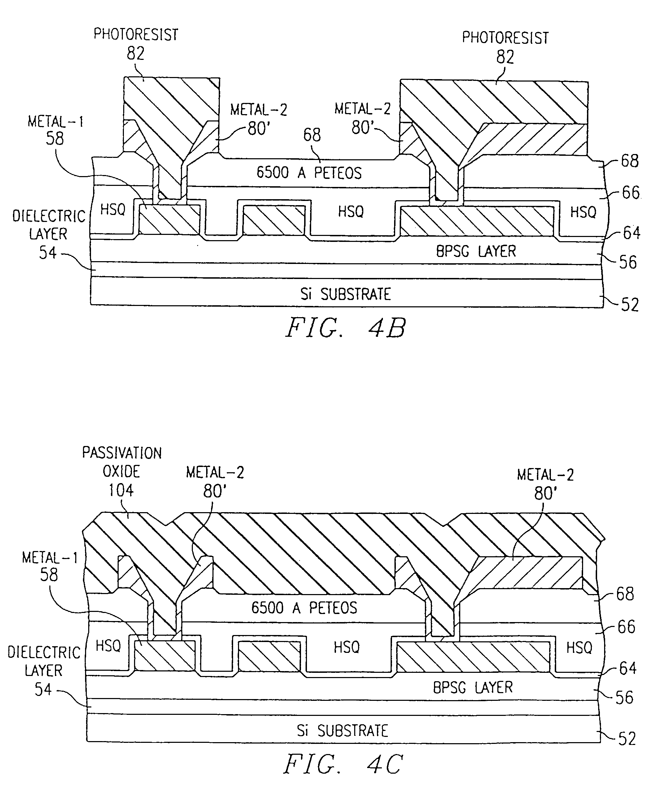

Details of a double or bi-layer metal process are illustrated in FIGS. 4A - 4C. With reference to FIG. 4A, there is illustrated a device under construction incident to double or bi-layer metal processing in a manner analogous to the stage of triple layer processing discussed above in connection with FIGS. 3A - 3F. Prior to sputtering the second metal stack 80', the wafer is exposed to an argon sputter etch and a low pressure bake to remove aluminum and residue from the bottom of the vias 72. Metal-2 stack 80' is comprised of ∼2,000 Å Ti (10 wt.%) -W and ∼6,000Å Al - Si (1 wt.%) - Cu (0.5 wt. %). As is illustrated in the drawing, the sputter process for the Metal-2 stack 80' partially fills the vias 72 with metal to create a path for electrical conduction between Metal-1 stack 58 and Metal-2 stack 80'. The Metal-2 layer 80' is patterned with photoresist 82 and etched in a manner described previously, with the metal over-etch removing about 2,000 Å PETEOS (FIG. 4B). Following removal of the photoresist 82, a layer of passivation oxide 104 is deposited, patterned and etched as shown in FIG. 4C, to render a planarized surface at the Metal-2 stack level.

The advantages of the foregoing planarization processes include excellent gap-fill characteristics and local planarization. Moreover, use of HSQ through the various processes is advantageous as HSQ exhibits an advantageously low (<3.0) dielectric constant. The improved planarization that results from the foregoing processes reduces defects caused by metal stringers, resulting in an increase in yield over conventional resist etch-back ("REB") processes now in use throughout the industry. As HSQ is a non-carbon based SOG compound, it does not require an etch back. Accordingly, vias etched through HSQ are not exposed to "via poisoning" arising from carbon out-gassing, as is experienced conventional ILD processes.

Electrical evaluation of HSQ-processed wafers indicates that HSQ SOG inter-layer dielectric processes can exhibit instances of via poisoning. This electrical abnormality is manifested when a via chain is initially measured with a low voltage, which indicates that the via is either "open" or exhibits an extremely high resistance. Stressing of the via chain with a moderate voltage results in via resistance levels that are normal for such structures. This change in via resistance levels is indicative of an organic barrier formed in the vias, which can understandably compromise via, and therefore circuit, performance. As the post via-ech cleansing process utilizes organic solvents which contact the HSQ in the vias, efforts were directed at this aspect of the overall cleansing process to evaluate both the source and nature of organic contamination. These studies indicated the complexing or other bonding of isopropyl alcohol ("IPA") to the surface of the structure. It is advantageous to remove IPA prior to sputtering the via liner, as IPA causes electrical failures due to its insulative properties. The discussion which follows addresses the various manners in which the bonded IPA can be removed from the via sidewalls, thereby enhancing circuit reliability.

A 24 wafer lot was processed as five discrete groups under the specific process regimens set forth in Table I below:

**Table I**

| Lot 1 | Lot 2 | Lot 3 | Lot 4 | Lot 5 |
|---|---|---|---|---|
| Wafers 1-5 | Wafers 6-10 | Wafers 11-15 | Wafers 16-20 | Wafers 21-24 |
| Via - Etch | Via - Etch | Via - Etch | Via - Etch | Via - Etch |
| Solvent | Solvent | Solvent | Solvent | Solvent |
| IPA Rinse | IPA Rinse | IPA Rinse | IPA Rinse | IPA Rinse |
| IPA Dry | IPA Dry | IPA Dry | IPA Dry | IPA Dry |
| Barrel Asher | Barrel Asher | Barrel Asher | Barrel Asher | Barrel Asher |
| Solvent | Solvent | Solvent | Solvent | Solvent |
| IPA Rinse | IPA Rinse | IPA Rinse | IPA Rinse | IPA Rinse |
| IPA Dry | IPA Dry | IPA Dry | IPA Dry | IPA Dry |
| Barrel Asher | -- | -- | -- | -- |
| -- | -- | 350°C | 400°C | -- |
| 225°C Degas; | 225°C Degas; | 225°C Degas; | 225°C Degas; | 70 sec, |
| *RGA Data | RGA Data | RGA Data | RGA Data | 300°C; Degas |
| Metal-2 Dep. | Metal-2 Dep. | Metal-2 Dep. | Metal-2 Dep. | Metal-2 Dep. |

| | | | | |
|---|---|---|---|---|
| * RGA represents Residual Gas Analyzer data, in which mass:charge ratios and electric field are utilized to obtain separation. | | | | |

Each of the foregoing wafers included 94 sites, each of which sites being provided with via chains totaling 500,000 vias/site, for a total test of 47,000,000 vias/wafer.

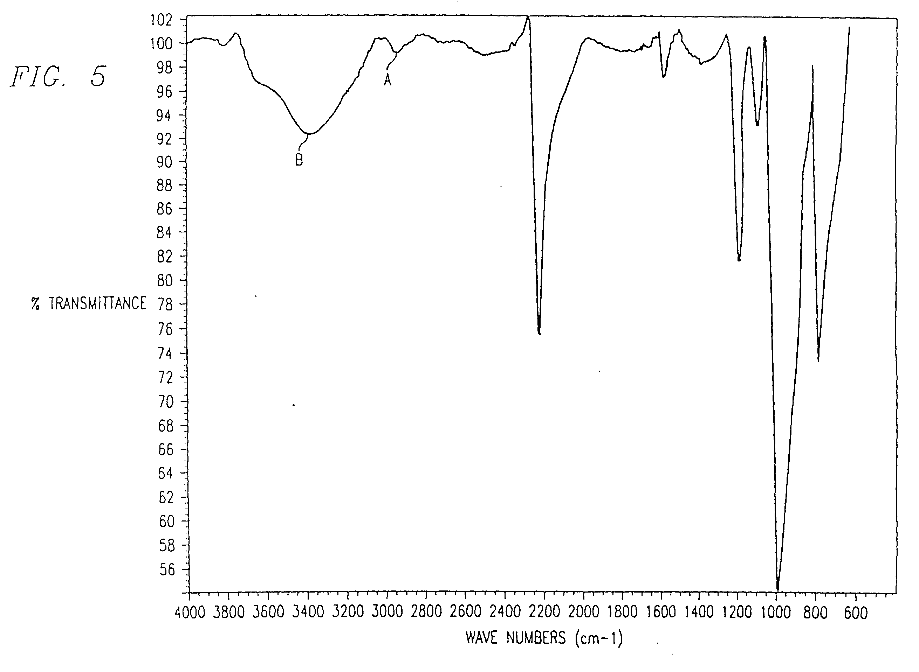

Following wafer cleaning and furnace processing, and prior to metal deposition, mass spectroscopy data was collected on one wafer from lots 1 - 4. The data was collected with an RGA (Residual Gas Analyzer) head that was connected to the degas chamber of an Applied Materials Endura Model 5500 (MT 109) while the wafer was processed for 5 min. at 400°C. Isopropal alcohol (IPA-mass 45) was detected from the wafers of lots 1 and 2, whereas no IPA was identified from lots 3 and 4. RGA data was not collected from lot 5 due toidentical processing of split 2 prior to metal deposition. Water (mass 18) was also detected on the wafers from lots 1 - 4. In this regard, it was assumed that the water arose from atmospheric moisture that was absorbed during the waiting period following wafer cleaning and furnace processing, and prior to collection of the RGA data. Electrical data that was collected from wafer lots 3 - 5, which lots received additional thermal processing steps compared to the wafers of lots 1 & 2, did not display the above-referenced shift in via chain resistance following voltage stress. Lots 1 & 2 both displayed the via-poisoning signature of a resistance shift following voltage stress, the the wafer from lot 1 (FIG. 5) having the more extreme stress. The via poisoning signature is illustrated in FIG. 5, at peaks designated "A" (∼3,060 cm⁻¹) and "B" (∼3,400 cm⁻¹). The signature at "A" indicates IPA bonded to HSQ, whereas the signature at "B" indicates IPA bonded to H₂O that, in turn, is bonded to HSQ.

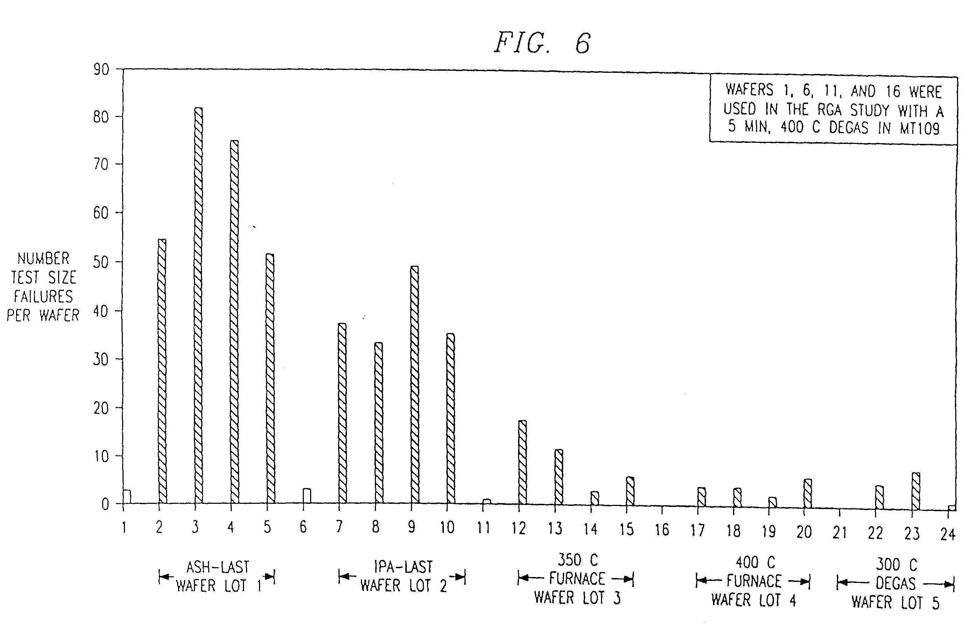

The foregoing poison signatures are manifested in test data that was collected for each of the 24 wafers of the five lots. With reference to FIG. 6, data collected from each wafer with respect to a 90 site test is illustrated in the form of "counts" or "test site failures" for each wafer. As is demonstrated in the graph, the wafers comprising lots 3 - 5 exhibited greatly diminished failure counts, evidencing the merits of wafer processing in accordance with the teachings of the present invention. The four wafers (nos. 11, 16, 21 & 24) that were evaluated in the RGA study, and which were processed for 5 min. at ∼400°C in MT 109 unit prior to the foregoing 225°C degas and metal deposition in MT 117, displayed a considerably reduced resistance shift and, correspondingly, considerably lesser numbers of test site failures.

The foregoing data suggests that incidence of via poisoning arising from IPA desorption during metal deposition can be considerably reduced by implementing a thermal processing regimen prior to metal deposition, as such thermal processing eliminates most, if not all, of the IPA (as well as H₂O) that is absorbed by the HSQ in the sidewalls of the vias. Thermal processing is preferably at a temperature of at least about 250°C, with a preferred furnace temperature range of about 300° - 400°C. Such furnace processing can be conducted in a horizontal furnace operable at atmospheric pressure (∼760 Torr) in an N₂ ambient for about 45 min. It is further preferred to process wafers prior to Metal-2 and Metal-3 deposition in a degas chamber, such as the AMT Endura 5500 discussed above, or other suitable degas equipment, at reduced pressure (10⁻⁶ - 10⁻⁸ Torr) and in the absence of an ambient atmosphere. In the contemplated degas procedure, the wafer would be exposed to heat (typically from Halogen lamps), and a thermocouple or similar temperature measuring device for measuring wafer temperature is employed to ramp wafer temperature to about 250°C or more for about 80 sec. at medium power, such as 52% power, during the temperature ramp. The actual wafer temperature and temperature ramping procedure can be customized for individual wafer processing applications, taking into account, among other factors, temperature stability of the circuit components present on the wafer during thermal processing. For example, certain low dielectric constant dielectrics are structurally unstable at temperatures much above about 400°C. Accordingly, it would be prudent when using such materials to lengthen processing time, at lower temperatures, to facilitate removal of IPA and/or H₂O from the vias prior to metal deposition.

Although the invention has been described with respect to a specific preferred embodiment thereof, many variations and modifications will immediately become apparent to those skilled in the art. For example, while the term "via" has been used throughout this specification, it is to be appreciated that channels or passages other than vias are contemplated for use in the processing regimen of the present invention. It is therefore the intention that the appended claims be interpreted as broadly as possible in view of the prior art to include all such variations and modification.

## Claims

1. A method of forming a planar intermetalic dielectric layer over an interconnect pattern on a wafer comprising the steps of:
providing a substrate having an electrical interconnect pattern thereon;
forming a first layer of dielectric over said interconnect pattern;
forming a second layer of dielectric different from said first layer over said first dielectric layer;
forming a third layer of dielectric different from said second layer over said second dielectric layer;
etching at least one via in said first layer of dielectric;
heating said substrate; and
depositing metal over said first layer of dielectric and into said at least one via.

2. The method of Claim 1, wherein said step of forming said comprises forming said first layer from a plasma generated TEOS oxide.

3. The method of Claim 1 or Claim 2, wherein said step of forming said second layer comprises forming said second layer from a silicon containing dielectric.

4. The method of Claim 3, wherein said step of forming said second layer comprise forming said second layer from an inorganic silicon containing composition.

5. The method of Claim 3 or Claim 4, wherein said step of forming said second layer comprises forming said second layer from a silicon-containing composition comprising HSQ.

6. The method of any preceding claim, wherein said step of forming said third layer comprises forming said third layer from a plasma generated TEOS oxide.

7. The method of any preceding claim, wherein said step of heating said substrate comprises heating said substrate to a temperature between approximately 350°C to 400°C.

8. The method of any of Claims 4 to 7, wherein the step of forming said second layer comprises the steps of depositing an inorganic silicon-containing composition capable of being pyrolytically converted to a silicon oxide over the wafer and placing the resulting structure in an essentially pure nitrogen and essentially moisture-free environment at a pressure at or below atmospheric pressure, heating the said silicon containing composition to a temperature of approximately 375°C to about 425°C for approximately 30 minutes to 90 minutes to convert said silicon-containing composition to silicon oxide.

9. The method of Claim 8, wherein said step of heating said silicon comprises heating said silicon to a temperature of approximately 400° C for approximately 45 minutes.

10. The method of any preceding claim, wherein the step of forming the said third layer comprises the steps of placing the wafer in a vacuum chamber and heating in a nitrogen ambient at a pressure of approximately 3 Torr to 15 Torr at a temperature of approximately 350°C to 430°C for approximately 30 seconds to 90 seconds and depositing a layer of plasma generated TEOS oxide with a thickness of approximately 2000 Angstroms to 4000 Angstroms over said structure.

11. The method of Claim 10, wherein said step of heating said substrate comprises heating the substrate to a temperature approximately 390°C for about 60 seconds.

12. The method of Claim 10 or Claim 11, wherein said step of placing the wafer in a vacuum chamber comprises placing said wafer in a vacuum chamber at a pressure of approximately 9 Torr.

13. The method of any of Claims 10 to 12, wherein said step of depositing a layer of plasma generated TEOS oxide comprises depositing a layer of plasma generated TEOS oxide having a thickness of approximately 3000 Angstroms.
